(19) Europäisches Patentamt

European Patent Office

Office européen des brevets

(11) **EP 0 677 182 B1**

(12) **EUROPEAN PATENT SPECIFICATION**

(45) Date of publication and mention
of the grant of the patent:
**08.03.2000 Bulletin 2000/10**

(21) Application number: **94904870.6**

(22) Date of filing: **20.12.1993**

(51) Int. Cl.[7]: **G03F 7/023**, C08G 8/24

(86) International application number:
**PCT/US93/12404**

(87) International publication number:
**WO 94/15259 (07.07.1994 Gazette 1994/15)**

(54) **METHOD FOR FORMING A NOVOLAK RESIN FOR PHOTORESIST APPLICATIONS**

VERFAHREN ZUR HERSTELLUNG EINES NOVOLAKHARZES FÜR ANWENDUNGEN IN
PHOTORESISTS

METHODE POUR LA PRODUCTION D'UNE RESINE NOVOLAK POUR APPLICATIONS DANS DES
PHOTORESERVES

(84) Designated Contracting States:
**DE FR GB IT**

(30) Priority: **29.12.1992 US 999529**

(43) Date of publication of application:
**18.10.1995 Bulletin 1995/42**

(73) Proprietor:
**Clariant Finance (BVI) Limited
Road Town, Tortola (VG)**

(72) Inventors:
• **SOBODACHA, Chester, J.
Coventry, RI 02818 (US)**
• **LYNCH, Thomas, J.
North Easton, MA 02356 (US)**
• **DURHAM, Dana, L.
Flemington, NJ 08822 (US)**

(74) Representative:
**Hütter, Klaus, Dr.
Clariant GmbH
Patente, Marken, Lizenzen
Am Unisys-Park 1
65843 Sulzbach (DE)**

(56) References cited:
EP-A- 0 109 062          EP-A- 0 118 291
EP-A- 0 496 640          EP-A- 0 529 969
DE-B- 1 022 005          US-A- 4 842 983

• **A. BACHMANN, K. MÜLLER 'Phenoplaste', 1973,
VEB DEUTSCHER VERLAG FOR
GRUNDSTOFFINDUSTRIE, LEIPZIG see page 44
- page 53**
• **PATENT ABSTRACTS OF JAPAN vol. 14, no. 571
(C-0970)19 December 1990 & JP,A,02 248 417
(KONDO KOICHI)**
• **A. KNOP, L. PILATO 'Phenolic Resins' 1985 ,
SPRINGER-VERLAG , BERLIN, HEIDELBERG,
NEW YORK, TOKYO see page 31 - page 34 see
page 46 - page 52**
• **PATENT ABSTRACTS OF JAPAN vol. 7, no. 34
(C-150)10 February 1983 & JP,A,57 187 311
(NAKATSUKA RIYUUZOU) 18 November 1982**

**Description**

BACKGROUND OF THE INVENTION

The present invention relates to a process for producing novolak resins made by selecting the reaction solvent according to its solvent power characteristics. The present invention also relates to a process for producing positive-working photoresist compositions containing novolak resins produced in this manner. Further, the present invention relates to a process for coating substrates with these photoresist compositions, then imaging and developing the photoresist compositions on the substrates.

Photoresist compositions are used in microlithography processes for making miniaturized electronic components such as in the fabrication of computer chips and integrated circuits. Generally, in these processes, a thin coating of film of a photoresist composition is first applied to a substrate material, such as silicon wafers used for making integrated circuits. The coated substrate is then baked to evaporate any solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the coated surface of the substrate.

There are two types of photoresist compositions, negative-working and positive-working. When negative-working photoresist compositions are exposed image-wise to radiation, the areas of the resist composition exposed to the radiation become less soluble to a developer solution (e.g. a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating, thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this development operation, the now partially unprotected substrate may be treated with a substrate-etchant solution or plasma gases and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the image-wise exposure of the radiation. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of one micron or less are necessary. In addition, it is almost always desirable that the developed photoresist wall profiles be near vertical relative to the substrate. Such demarcations between developed and undeveloped areas of the resist coating translate into accurate pattern transfer of the mask image onto the substrate.

SUMMARY OF THE INVENTION

The present invention relates to a process for producing novolak resins by selecting the reaction solvent according to its solvent power characteristics. The invention further relates to a process for producing positive-working photoresists containing novolak resins produced in this manner, The invention also relates to a process for producing semiconductor devices by coating a suitable substrate with such a positive-working photoresist, then imaging and developing the photoresist on the substrate.

The invention provides a method for adjusting the molecular weight and dissolution rate of an alkali soluble, film forming novolak resin having a high relative molecular weight and fast dissolution rate, the method comprising:

a) providing an admixture of formaldehyde and one or more phenolic compounds, such as meta-cresol, para-cresol, 3,5-xylenol, and 2,4-xylenol, and a catalytic amount of an acid catalyst such as oxalic acid or maleic anhydride;

b) providing a suitable reaction solvent or solvent mixture having a polarity of from 3.3 to 7.0 and a hydrogen bonding capability of from 7.6 to 12.3, except diglyme and ethyl cellosolve actetate;

c) providing a reaction mixture of the formaldehyde/phenolic compounds admixture in the reaction solvent; and

d) reacting the reaction mixture to thereby produce a novolak resin that is the condensation product of the formaldehyde and the phenolic compounds.

The invention also provides a method for producing a positive photoresist composition, the method comprising:

a) providing an admixture of formaldehyde, one or more phenolic compounds and a catalytic amount of an acid catalyst in a suitable reaction solvent having a polarity and a hydrogen bonding capability as described above;

b) condensing the admixture to thereby produce an alkali soluble, film forming novolak resin having a high relative molecular weight and a high dissolution rate;

c) providing an admixture of:

1) a photosensitive component in an amount sufficient to uniformly photosentitize the photoresist composition;

2) the novolak resin of b), the novolak resin being present in an amount sufficient to form a substantially uniform photoresist composition; and

3) a suitable photoresist solvent, to thereby produce a photoresist composition.

The invention further provides a method for producing a semiconductor device by providing a photoresist image on a substrate by coating a suitable substrate with a positive working photoresist composition, the method comprising:

a) providing an admixture of formaldehyde, one or more phenolic compounds and a catalytic amount of an acid catalyst in a suitable reaction solvent having a polarity and a hydrogen bonding capability as described above;

b) condensing the admixture to thereby produce an alkali soluble, film forming novolak resin having a high relative molecular weight and a high dissolution rate;

c) providing an admixture of:

1) a photosensitive component in an amount sufficient to uniformly photosensitize the photoresist composition;

2) the novolak resin of b), the novolak resin being present in an amount sufficient to form a substantially uniform photoresist composition; and

3) a suitable photoresist solvent, to thereby produce a photoresist composition;

d) coating a suitable substrate with the photoresist composition;

e) heat treating the coated substrate until substantially all of the solvent is removed;

f) image-wise exposing the photosensitive composition; and

g) removing the image-wise exposed areas of the photoresist composition with an aqueous alkaline developer. Optionally one may perform a baking of the substrate either immediately before or after the removing step.

DETAILED DESCRIPTION OF THE PREFERRED EMBODIMENTS

In the production of the relief image of the present invention, one coats and dries the foregoing photoresist composition on a suitable substrate.

Novolak resins have been commonly used in the art of photoresist manufacture as exemplified by "Chemistry and Application of Phenolic Resins", Knop A. And Scheib, W.; Springer Verlag, New York, 1979 in Chapter 4. Similarly, o-quinone diazides are well known to the skilled artisan as demonstrated by "Light Sensitive Systems", Kosar, J.; John Wiley & Sons, New York, 1965 Chapter 7.4.

Novolak resins continue to be the resin of choice for use in today's positive photoresists. Traditional preparations of Novolak resins involve reacting cresol momoners with formaldehyde in the presence of an acid catalyst at elevated temperatures. The preparations may be neat or may contain solvents. Novolak resin performance in positive photoresist has been typically optimized by varying the type and amount of cresol monomers, of catalyst and of formaldehyde. The process of the present invention provides a method to change and optimize the performance of novolak resins by selecting solvents with certain solvent power characteristics. The advantage of this method is the ability to use solvent selection to "fine tune" a novolak resin and positive photoresist performance. Solvent polarity and hydrogen bonding capability affect the relative molecular weight (RMW) and dissolution rate of a novolak resin. RMW is a viscosity measurement which is proprotional to the degree of novolak resin polymerization, and dissolution rate is the rate at which a thin novolak resin film dissolves in developer solution. Both RMW and dissolution rate affect optimum positive photoresist performance.

A system for measuring solvent power is Hansen's Soubility Parameter Therory. Solubility parameter theory is a semi-empirical system used to characterize solvents based on the cohesive forces (energies) which hold them together. The Hansen parameters divide the total cohesive force of a solvent into the three components: 1) dispersion forces (represented by delta d), 2) polarity forces (represented by delta p), and 3) hydrogen-bonding forces (represented by delta h). The vector sum of Hansen's three paramters is equal to the total solubility parameter (delta t), described by Hildebrand, according to the following equation:

$$(\text{delta t})^2 = (\text{delta d})^2 + (\text{delta p})^2 + (\text{delta h})^2.$$

Solubility parameter theory also assumes that miscible solvents have similar parameters, while non-miscible solvents have parameters which are dissimilar. The effective solubility parameter of a mixture is proprotional by volume to the parameters of the individual solvent components. Tables of solubility parameters for various solvents can be found in the CRC Handbook of Solubility Parameters and Other Cohesion Parameters, and these values can relate solvent power to many other physical and chemical properties. We have found that direct substitution of one solvent for another in the preparation of a novolak resin can change resin properties.

However, the instant invention has found that in the production of novolak resins the use of reaction solvents having a suitable, preferably high, polarity, and suitable, preferably low, hydrogen bonding capability, during the condensation reaction, provides a novolak resin having a high relative molecular weight (for thermal stability) and a fast dissolution rate (for improved photospeed).

In a particularly preferred embodiment, the present invention relates to a process for producing high relative molecular weight, high disolution rate novolak resins by controling the polarity and hydrogen bonding capability of the "total solvent" in the reaction mixture. Total solvent includes everything in the reaction mixture except the novolak resin produced. This includes the phenolic compounds and formaldehyde before they undergo condensation, as well as the conventional solvents in the reaction mixture. Since certain solubility parameters of the actual solvents affect the properties of the novolak resin produced, one can further control the properties of the novolak resin by controling the solubility parameters, i.e. polarity and hydrogen bonding capability, of the total solvent in the reaction mixture. Controlling the solubility parameters of the reaction mixture may be accomplished as the reaction proceeds and the cresols and formaldehyde are consumed by the condensation reaction. This may be done by adding additional reaction solvent as the reaction proceeds, to maintain a total solvent with a suitable polarity and suitable hydrogen bonding capability throughout the condensation reaction. In a preferred embodiment, the polarity and hydrogen bonding capability are kept substantially constant during the reaction.

The resulting novolak resin has a preferred molecular weight in the range of from about 600 to about 20,000, or more preferably from about 8,000 to about 12,000.

The condensation may be conducted by heating the reaction mixture at a temperature from about 60°C to about 150°C for a period of from about 1 hour to about 12 hours.

The sensitizer which comprises a component of the photoresist composition of the present invention may be an ester of multihydroxy phenolic or alcoholic compound, preferably a hydroxybenzophenone and a sulfonic acid or sulfonic acid derivative such as a sulfonyl chloride, such as described in U.S. Patents 3,106,465 and 4,719,167, which are incorporated herein by reference.

The photoresist composition is formed by blending the ingredients in a suitable solvent. In the preferred embodiment, the amount of novolak resin in the photoresist preferably ranges from 60% to about 95% and more preferably from about 70% to about 90% based on the weight of the solid; i.e., non-solvent photoresist components. In a preferred embodiment, the photosensitizer is present in the photoresist in an amount of from about 5% to about 40%, preferably from about 10% to about 30%, based on the weight of the solid photoresist components. In producing the photoresist composition, the novolak resin and sensitizer are mixed with such photoresist solvents or solvent mixtures as propylene glycol mono-alkyl ether, propylene glycol alkyl ether acetate, butyl acetate, xylene, ethylene glycol monoethyl ether acetate, propylene glycol mono-methyl ether acetate, ethyl lactate, ethyl-3-ethoxypropionate, and mixtures of ethyl lactate and ethyl-3-ethoxypropionate, among others; having polarity of from 3.3 to 7.0 and a hydrogen bonding capability of from 7.6 to 12.3.

Other optional ingredients such as colorants, dyes, anti-striation agents, leveling agents, plasticizers, adhesion promoters, speed enhancers, solvents and such surfactants as non-ionic surfactants may be added to the solution of novolak resin, sensitizer and solvent before the solution is coated onto a substrate. Examples of dye additives that may be used together with the photoresist compositions of the present invention include Methyl Violet 2B (C.I. No. 42535), Crystal Violet (C.I. 42555). Malachite Green (C.I. No. 42000), Victoria Blue B (C.I. No. 44045) and Neutral Red (C.I. No.

50040) at one to ten percent weight levels, based on the combined weight of novolak and sensitizer. The dye additives help provide increased resolution by inhibiting back scattering of light off the substrate.

Anti-striation agents may be used at up to about a five percent weight level, based on the combined weight of resin and sensitizer. Plasticizers which may be used include, for example, phosphoric acid tri-(beta-chloroethyl)-ester; stearic acid: dicamphor; polypropylene; acetal resins; phenoxy resins; and alkyl resins, at about one to ten percent weight levels, based on the combined weight of novolak and sensitizer. The plasticizer additives improve the coating properties of the material and enable the application of a film that is smooth and of uniform thickness to the substrate.

Adhesion promoters which may be used include, for example, beta-(3,4-epoxy-cyclohexyl)-ethyltrimethoxysilane; 1,1,1,3,3,3-hexamethyl disilazane; p-methyl-disilane-methyl methacrylate; vinyltrichlorosilane; and gamma-amino-propyl triethoxysilane up to about a 4 percent weight level, based on the combined weight of resin and sensitizer. Development speed enhancers that may be used include, for example, picric acid, nicotinic acid or nitrocinnamic acid up to about a 20 percent weight level, based on the combined weight of novolak and sensitizer. These enhancers tend to increase the solubility of the photoresist coating in both the exposed and unexposed areas, and thus they are used in applications when speed of development is the overriding consideration even though some degree of contrast may be sacrificed; i.e., while the exposed areas of the photoresist coating will be dissolved more quickly by the developer, the speed enhances will also cause a larger loss of photoresist coating from the unexposed areas.

The coating solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol; octylphenoxy ethanol at up to about 10% weight levels, based on the combined weight of resin and sensitizer.

The prepared photoresist solution, can be applied to a substrate by any conventional method used in the photoresist art, including dipping, spraying, whirling and spin coating. When spin coating, for example, the resist solution can be adjusted with respect to the percentage at solids content, in order to provide coating at the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds.

The photoresist coatings produced by the described procedure are particularly suitable for application to thermally grown silicon/silicon dioxide-coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing hexa-alkyl disilazane.

The photoresist composition solution is then coated onto the substrate, and the substrate is treated at a temperature from about 70°C to about 110°C for from about 30 seconds to about 180 seconds on a hot plate or for from about 15 to about 90 minutes in a convection oven. This temperature treatment is selected in order to reduce the concentration of residual solvents in the photoresist, while not causing substantial thermal degradation of the photosensitizer. In general, one desires to minimize the concentration of solvents and this first temperature treatment is conducted until substantially all of the solvents have evaporated and a thin coating of photoresist composition, on the order of one micron in thickness, remains on the substrate. In a preferred embodiment the temperature is from about 85°C to about 95°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist is then optionally subjected to a post exposure second baking or heat treatment either before or after development. The heating temperatures may range from about 90°C to about 120°C, more preferably from about 100°C to about 110°C. The heating may be conducted for from about 30 seconds to about 2 minutes, more preferably from about 60 seconds to about 90 seconds on a hot plate or about 30 to about 45 minutes by convection oven.

The exposed photoresist-coated substrates are developed to remove the image-wise exposed areas by immersion in an alkaline developing solution or developed by spray development process. The solution is preferably agitated, for example, by nitrogen burst agitation. The substrates are allowed to remain in the developer until all, or substantially all, of the photoresist coating has dissolved from the exposed areas. Developers may include aqueous solutions of ammonium or alkali metal hydroxides. One preferred hydroxide is tetramethyl ammonium hydroxide. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silicon dioxide-type substrates, the developed substrates may be treated with a buffered, hydrofluoric acid base etching solution. The photoresist compositions of the present invention are resistant to acid-base etching solutions and provide effective protection for the

EP 0 677 182 B1

unexpose photoresist-coating areas of the substrate.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

Example 1 (Comparison)

A novolak resin was prepared in the following manner:

A sealable reactor was charged with 90.69 g mixed cresols (5:3 M-Cresol:3,5-Xylenol), 0.22 g oxalic acid, and 60 g diglyme. The mixture was heated to 95°C with stirring and 47.12 g of approximately 37% aqueous formaldehyde was added over 90 minutes. The reactor was then sealed. The reaction mixture was then heated for 4 hours at 95°C. At the end of the 4 hour reaction period, the reactor was converted for distillation and the temperature raised to 190°C and the pressure allowed to fall below 20mm Hg. The vacuum was then released, the molten resin collected and cooled.

Example 2-5

Novolak resins were prepared according to the procedure of Example 1, except that different solvents were used as described in the following Table 1.

Table 1

| Example | Solvent or Solvent Mixtures |
|---|---|
| 2(Comparison) | diglyme |
| 3(Comparison) | dipropylene glycol methyl ether (DPGME) |
| 4,5 | xylene:DPGME, 1:3 [(Volume:Volume (V:V)] |

Example 6 (Comparison)

A novolak resin was prepared in the following manner:

A sealable reactor was charged with 90.69 g of the mixed cresols of Example 1, 0.45 g oxalic acid, and 60 g dioxane. The mixture was heated to 95°C with stirring and 47.12 g of approximately 37% aqueous formaldehyde was added over 90 minutes. The reactor was then sealed. The reaction mixture was then heated for 4 hours at 95°C. At the end of the 4 hour reaction period, the reactor was converted for distillation and the temperature raised to 190°C. At this point the temperature was raised to 210°C and the pressure allowed to fall below 20mm Hg. The vacuum was then released, the molten resin collected and cooled.

Examples 7-24

Novolak resins were prepared according to the procedure of Example 6, except that different solvents were used as described in the following Table 2:

Table 2

| Example | Solvent or Solvent Mixture |
|---|---|
| 7, 8 | diglyme (Comparison) |
| 9, 10, 11 | 2-ethyl-1-hexanol (Comparison) |
| 12, 13, 14 | DPGME (Comparison) |
| 15, 16 | xylene:2-ethyl-1-hexanol (1:3, V:V) |
| 17, 18, 19, 20, 21 | xylene:DPGME (1:3, V:V |
| 22 | gamma-butyrolactone:diglyme (1:3, V:V) |

6

Table 2 (continued)

| Example | Solvent or Solvent Mixture |
|---|---|
| 23 | gamma-butyrolactone:diglyme (1:1, V:V) |
| 24 | gamma-butyrolactone:DPGME (1:1, V:V) |

Example 25

Dissolution Rate Procedure for Novolak Resins

Formulations:

26% resin solids were dissolved in propylene glycol methyl ether acetate (PGMEA) and filtered through a 0.2 μm disposable Acrodisc filter.

Spin Speed Determinations for 1.5 μm Films:

For each sample, three waters were spun at the following speeds: 1500, 2500, and 3500 rpm/30 seconds. All wafers were baked at 90°C for 30 minutes in a forced air oven. Film thickness was measured at n=1.64, using a Rudolf Film Thickness Monitor and the speed requited for 1.5 μm films by logarithmic (base 10) regression was interpolated.

Dissolution Rate Procedure:

1. For each sample, 3 wafers were spun coated at the appropriate speed to obtain 1.5 μm films.
2. All wafers were baked at 90=/-1°C for 30 minutes.
3. The thickness of each film, in μm was determined at n=1.64, using a Rudolf Film Thickness Monitor.
4. All sample films individually developed with no agitation in 2.38% tetramethylammonuim hydroxide at 25+/-0.5°C. Film loss during development was monitored by interferometry using a XINIX End-Point Controller. The dissolution rate was calculated from the interferogram. The average dissolution for each sample was determined.

Example 26

A 7% solution of the resin (1.75 grams in 25.00 ml volumetric flask) was made in cyclohaxanone solvent. The solution was filtered through a 5 micron membrane syringe filter. A size #100/#200 viscometer was filled in the inverse position to the second line. The viscometer was placed in the viscosity bath at 25°C (constant temperature0 for 15-20 minutes. The flow time of the resin solution (sec.) was taken and repeated until two consistent readings were obtained. The solvent flow checked time in the same manner.

Calculation:

$$RMW=[\log(\text{flow time of resin solution/solvent flow time})/\text{conc.}(0.07)]^2$$

Example 27

Calculation of Effective Solubility Parameters for Solvent Mixtures

The effective solubility parameter [expressed as the square root of Mega Pascals, $(MPa)^{1/2}$] of a solvent mixture was proprotional, by volume, to the solubility parameters of the individual components. The effective solubility parameter of two solvents mixed together in equal volumes was equal to the average of the solubility parameters of the individual solvents.

The effective delta h of a mixture of 1 part by volume xylene and 3 parts by volume DPGME (25% xylene and 75% DPGME by volume) was calculated as follows:

delta h (xylene) = 3.1

delta h (DPGME) = 12.7

effective delta h (1:3, xylene:DPGME, V:V) = 3.1(0.25) + 12.7(0.75) = 10.3

Example 28

The novolak resins prepared in Examples 1-5 were formulated and tested for Dissolution Rate and RMW, as described in Examples 25 and 26. As can be seen in Table 3 below, the novolak resin prepared from diglyme had an RMW of approximately 9.4 and an average Dissolution Rate of 2.85 µm/min. The novolak resin prepared from DPGME has an RMW of 9.8, but a much slower dissolution rate of 1.04 µm/min. A possible cause for this change is the difference in hydrogen-bonding capability between the two solvents. DPGME has a free hydroxyl group and a delta h of 12.7, while diglyme has no free hydroxyl group and a delta h of 9.2. Xylene and DPGME can be mixed in a 1:3 xylene:DPGME (V:V) ratio to produce a mixture with an effective delta h of 10.3, comparable to diglyme. Novolak resins prepared from this xylene:DPGME mixture had RMW's and Dissolution Rates comparable to novolak resins prepared from diglyme. This shows that solubility parameters can be very effective in designing preparations for resins with specific properties.

Table 3

| Solvent | delta p | delta h | RMW | dissrate, µm/min |
|---|---|---|---|---|
| diglyme | 6.1 | 9.2 | 9.5 | 2.60 |
| diglyme | 6.1 | 9.2 | 9.3 | 3.10 |
| DPGME | 7.8 | 12.7 | 9.8 | 1.04 |
| xylene:DPGME 1:3 | 6.1 | 10.3 | 9.1 | 3.05 |
| xylene:DPGME 1:3 | 6.1 | 10.3 | 9.6 | 2.69 |

Example 29

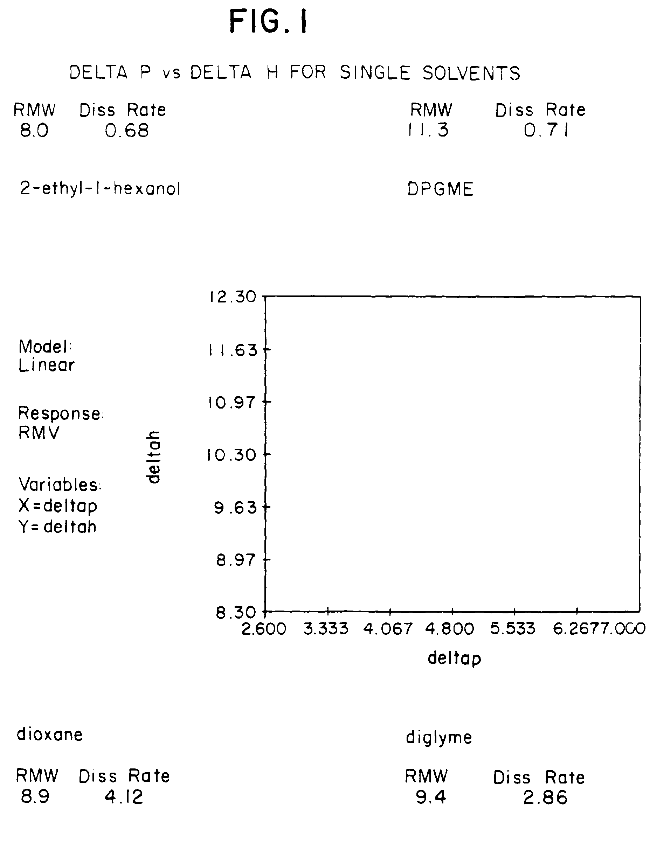

To more completely understand the effects of solubility parameters in resin synthesis, a full factorial designed experiment was performed. The factors were delta p and delta h and the responses were RMW and Dissolution Rate. This desinged experiment was viewed as a square with the corners representing the delta p.delta h combinations, as shown in Fig. 1. A single solvent with appropriate solubility parameters was chosen for each corner experiment. Resins were prepared using each solvent (corner experiment) according to the procedures of Examples 6-14. Replicate resins were prepared to determine experimental error. A diagram of the desinged experiment is shown below with RMW and Dissolution Rates given as averages. Table 4 below shows the results of all the individual corner experiments and includes the residual monomer and solvent in the resins.

| Factor Levels | | | |
|---|---|---|---|
| Factors | Low Value | High Value | Responses |
| delta p | 3.3 | 7.0 | RMW |
| delta h | 7.6 | 12.3 | dissolution rate |

Table 4

| Solvent Used | Delta P | Delta H | RMW | Diss Rate (µm/min) | Residual Monomers (wt.%) | Residual Solvent (wt.%) |
|---|---|---|---|---|---|---|
| dioxane | 2.6 | 8.3 | 8.9 | 4.12 | 1.1 | 1.6 |

Table 4 (continued)

| Solvent Used | Delta P | Delta H | RMW | Diss Rate (μm/min) | Residual Mono-mers (wt.%) | Residual Solvent (wt.%) |
|---|---|---|---|---|---|---|
| diglyme | 7.0 | 8.3 | 9.5 | 2.59 | 0.76 | 0.23 |
| diglyme | 7.0 | 8.3 | 9.3 | 3.14 | 1.20 | 0.64 |
| 2-ethyl-1-hexanol | 2.6 | 12.3 | 8.5 | 1.02 | 0.34 | 0.60 |
| 2-ethyl-1-hexanol | 2.6 | 12.3 | 7.4 | 0.30 | 1.2 | 2.1 |
| 2-ethyl-1-hexanol | 2.6 | 12.3 | 8.1 | 0.73 | 0.40 | 0.10 |
| DPGME | 7.0 | 12.3 | 11.0 | 0.52 | 1.1 | 1.1 |
| DPGME | 7.0 | 12.3 | 10.3 | 0.88 | 0.40 | 0.20 |
| DPGME | 7.0 | 12.3 | 12.5 | 0.73 | 0.37 | 0.28 |

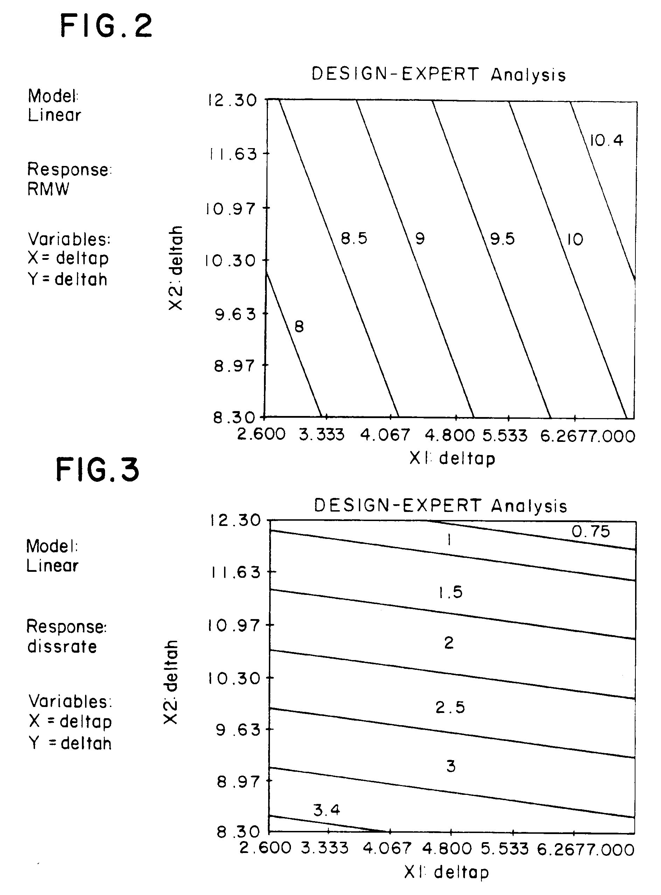

The results of Example 29 indicate that resin RMW increased with increasing solvent polarity (delta p) and increasing solvent hydrogen-bonding capability (delta h). Resin Dissolution Rate decreases with increasing hydrogen-bonding capability (delta h), but does not appear to be significatnly affected by changes in solvent polarity (delta p). Conour plots for RMW and dissolution rate responses are shown in Figs. 2 and 3.

Example 30

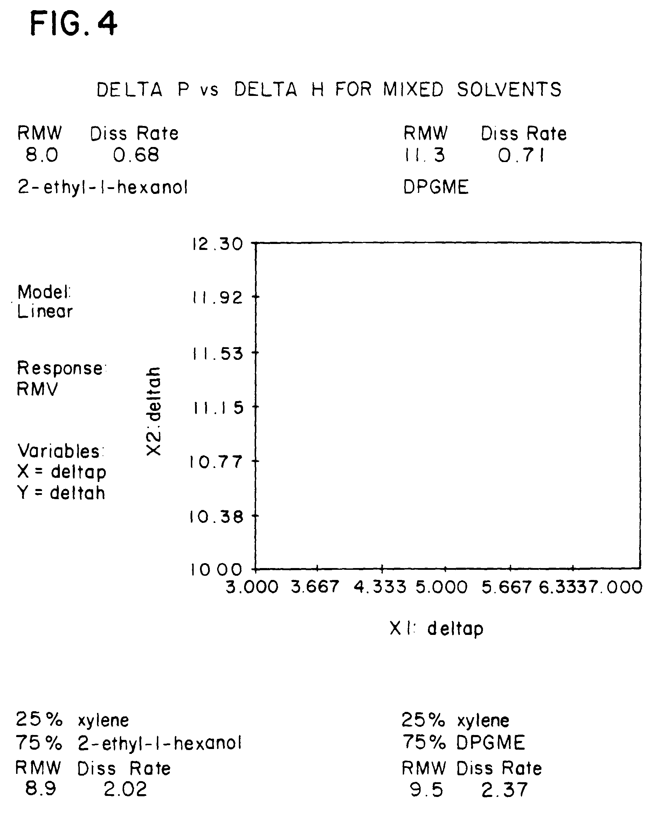

A second designed experiment was performed replacing dioxane with the mixed solvent 25% xylene/75% 2-ethyl-1-hexanol and replacing diglyme with the mixed solvent 25% xylene/75% DPGME. 25% xylene/75% 2-ethyl-1-hexanol (delta h=10.0) has a delta h only slightly higher than dioxane (delta h=8.3) and comparable delta p(3.0 vs 2.6); the delta h of 25% xylene/75% DPGME (10.0) is slightly higher than diglyme (8.3), but delta p's (7.0 vs 7.0) are the same. This designed experiment was performed in a manner comparable to Example 29; replicate resins were prepared for each "corner" solvent under otherwise identical conditions according to the procedures of Examples 9-21. A diagram of the designed experiment is shown in Fig. 4 with response averages given for each solvent. Table 5 below shows the results of all replicate experiments.

Table 5

| Properties of Resins Prepared for Experimental Design Delta p vs Delta h (Mixed Solvents) | | | | | | |
|---|---|---|---|---|---|---|
| Solvent Used | Delta P | Delta H | RMW | Diss Rate (μm/min) | Residual Mono-mers (wt%) | Residual solvent (wt.%) |
| 75% 2-ethyl-1-hexanol | 3.0 | 10.0 | 9.4 | 1.76 | 1.1 | 1.2 |
| 25% xylene | | | 7.8 | 2.29 | 0.47 | 1.9 |
| 75% DPGME 25% xylene | 7.0 | 10.0 | 9.6 | 2.69 | 0.43 | 0.91 |
| | | | 9.4 | 2.07 | 0.86 | 1.5 |
| | | | 9.6 | 2.24 | 0.61 | 0.67 |
| | | | 9.6 | 2.27 | 0.40 | 0.52 |
| | | | 9.3 | 2.60 | 0.64 | 1.0 |
| 2-ethyl-1-hexanol | 3.0 | 12.3 | 8.5 | 1.02 | 0.34 | 0.60 |
| | | | 7.4 | 0.30 | 1.2 | 2.1 |
| | | | 8.1 | 0.73 | 0.40 | 0.10 |
| DPGME | 7.0 | 12.3 | 11.0 | 0.52 | 1.1 | 1.1 |

Table 5 (continued)

| Properties of Resins Prepared for Experimental Design Delta p vs Delta h (Mixed Solvents) | | | | | | |
|---|---|---|---|---|---|---|
| Solvent Used | Delta P | Delta H | RMW | Diss Rate (µm/min) | Residual Monomers (wt%) | Residual solvent (wt.%) |
| | | | 10.3 | 0.88 | 0.40 | 0.20 |
| | | | 12.5 | 0.73 | 0.37 | 0.28 |

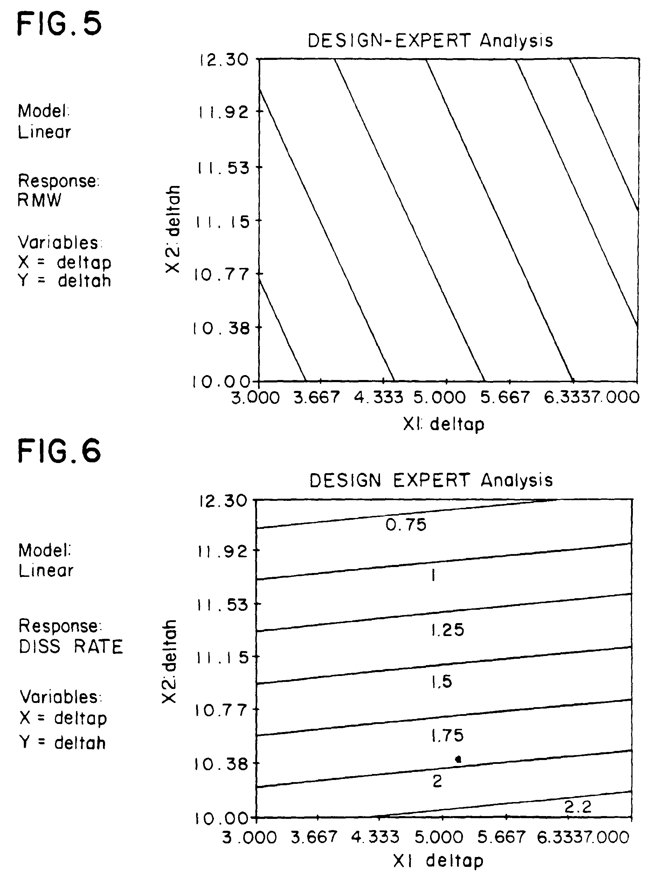

The results of this designed experiment were similar to the results of Example 29. RMW increased with increasing delta p and delta h, while dissolution rate decreased with increasing delta h, but was not significantly affected by changes in delta p. Contour plots for both responses of this desinged experiment are shown in Figs. 5 and 6.

Example 31

A photoresist was made by dissolving 20 g of the novolak resin prepared in Example 17 (from 25% xylene and 75% DPGME solvent mixture) with 5 g of a photoactive compound composed of 30 wt.% 2,1,4- and 70 wt.% 2,1,5-diazonaphtoquinone esters of 1,1,1-Tris(4-hydroxyphenyl)ethane; and 75 g of propylene glycol methyl ether acetate used as the solvent. 300 ppm of surfactant (FC-430 available from 3M Corp.) was added to prevent formation of striations in the spin cast film.

The resist was spin-case onto a silicon wafer and baked at about 95°C on a hot plate for about 60 seconds to give a 1 µm film. The resist film was image-wise exposed using a Nikon 0.54 N.A. I-line stepper under a variety of linewidths, exposure, and focus conditions. The exposed wafer film was then developed in 2.38% tetramethylammonium hydroxide. A scanning electron micrograph showed that 0.35 µm resolution was obtained.

Example 32

Using the same scale for the delta p and delta h axes, the contour plots from Example 30 were almost identical to the contour plots from Example 29. This shows that resin properties are correlated to the solubility parameters of the solvent or solvent mixture, not merely to a specific solvent. A resin prepared with 25% xylene/75% DPGME was almost identical in RMW and Dissolution Rate to a resin prepared in diglyme. The composition of 25% xylene/75% DPGME was calculated so that its solubility parameters approximate those of diglyme. The lithographic properties of a photoresist prepared with 25% xylene/75% DPGME (RMW=9.6, Dissolution Rate=2.69) were excellent; 0.35 µm resolution with 2220 millijoules (mj) photospeed was achieved.

Example 33

Examples 29 and 30 suggest that a solvent or solvent mixture with high polarity (high delta p) but low hydrogen-bonding capability (low delta h)) produced a resin with high RMW for thermal stability and a fast Dissolution Rate, for improved photospeed. Novolak resins were prepared from solvent mixtures of gamma-butyrolactone (BLO)/Diglyme and BLO/DPGME according tot he procedures of Examples 22-24, using solvents having higher delta p values and lower delta h values than were used in both prior experimental designs (see Table 6 below). All these resins had high RMW and fast Dissolution Rates when compared to the results of both prior experimental designs, supporting the conclusion that high delta p and low delta h solvents produce resins having good lithographic properties.

Table 6

| Properties of Resins Prepared with BLO/Diglyme and BLO/DPGME Solvent Mixtures | | | | | | |
|---|---|---|---|---|---|---|
| Solvent Used | Delta P | Delta H | RMW | Diss Rate | Residual Monomers (wt%) | Residual solvent (wt%) |
| 25% BLO, 75% Diglyme | 8.8 | 8.8 | 9.7 | 3.9 | 0.36 | 0.88 |
| 50% BLO, 50% Diglyme | 11.4 | 8.3 | 10.5 | 1.96 | 0.64 | 0.73 |

Table 6 (continued)

| Properties of Resins Prepared with BLO/Diglyme and BLO/DPGME Solvent Mixtures | | | | | | |
|---|---|---|---|---|---|---|
| Solvent Used | Delta P | Delta H | RMW | Diss Rate | Residual Monomers (wt%) | Residual solvent (wt%) |
| 50% BLO, 50% DPGME | 12.2 | 10.1 | 9.7 | 2.6 | 0.45 | 1.8 |

Example 34

A novolak resin was prepared in the following manner:

To a sealable reactor equipped with thermometer, dropping funnel, stirrer, heater, and distiallation condenser were added 136 grams of the mixed cresols of Example 1, 0.68 grams of oxalic acid, 90.0 grams of DPGME solvent, and 71.1 grams of 37% aqueous formaldehyde. The reactor was sealed. The reaction temperature was raised to 95°C and mainted at 95°C for a reaction period of 5.5 hours. During the 5.5 hours a total of 60 ml. of xylene was added at a constant rate through a dropping funnel. After the 5.5 hour reaction period, the reaction mixture was distilled at atmospheric pressure until it reached 190°C. At this time vacuum was drawn and the reaction mixture was vacuum distilled until the temperature reached 210°C. The temperature was maintained at 210°C and distillation continued for 10 minutes, after which time vacuum was released and the molten resin was collected.
The addition of xylene to the reaction mixture during the reaction period kept the effective delta h of the reaction mixture at a relatively constant value of about 17.

Example 35

A novolak resin was prepared in the following manner:

To a selable reactor equipped with thermometer, dropping funnel, stirrer, heater, and distillation condenser were added 136 grams of mixed cresols of Example 1, 0.68 grams of oxalic acid, 90.0 grams of DPGME solvent, 80.0 ml. of water, and 71.1 grams of 37% aqueous formaldehyde. The reactor was sealed. The reaction tmperature was raised to 95°C and maintained at 95°C for a reaction period of 5.5 hours. During the 5.5 hours, a total of 80 ml. of xylene was added at a constant rate through a dropping funnel. After the 5.5 hour reaction period, the reaction mixture was distilled at atmospheric pressure until the temperature reached 190°C. At this time vacuum was drawn and the reaction mixture was vacuum distilled until the temperature reached 210°C. The temperature was maintained at 210°C and distillation continued for 10 minutes, after which time vacuum was relased and the molten resin was collected.
The addition of water to the initial reaction charge and xylene to the reaction mixture during the reaction period kept the effective delta h of the reaction mixture at a relatively constant value of about 21.

Example 36

The "total solvent" in the resin preparation can be considered a varying mixture of cresols, organic solvent, water and methanol. Calculations of the effective solubility parameters of the "total solvent" used in the preparation of the novolak resin in Example 3 indicate both delta p and delta h increase dramatically during the course of the reaction (see Table 7 below).

Table 7

| Change in Effective Solubility Parameters of "Total Solvent"* | | |
|---|---|---|
| Reaction Step | Effective Delta P | Effective Delta H |
| Initial Charge Cresols/Solvent | 6.2 | 12.8 |
| Addition of Aqueous Formaldehyde | 8.7 | 16.3 |
| Reaction Completed | 12.6 | 21.3 |

\* contributions by the novolak resin to the effective solubility parameter have not been included in these calculations.

Since it was shown that solubility parameters of the solvent affect resin properties, one can alter resin properties by changing the effective solubility parameters of the "total solvent". A constant effective solubility parameter could be accomplished by concurrent addition of a co-solvent with lower delta p and delta h values, such as xylene.

Table 8 below shows that the properties of the two resins prepared in Examples 34 and 35 differ dramatically. The resin in Example 34 was prepared with a "total solvent" delta h of about 17 while the resin in Example 35 was prepared with a "total solvent" delta h of about 21. The increase in delta h produced a resin with lower RMW and faster dissolution rate. Initially this appears to contradict the results obtained in Examples 29 and 30, but it must be noted that in Examples 34 and 35, the delta h was maintained at constantly higher levels throughout the whole reaction, all reactants were initially charged to the pot, and reaction volumes were much greater due to the additional water and xylene.

Table 8

| Resin Properties with Constant Effective Delta H | | | | | |
|---|---|---|---|---|---|
| Resin | Constant Delta H | RMW | Diss Rate | Residual Monomer (wt.%) | Residual Solvent (wt %) |
| Example 34 | 17 | 11.4 | 0.75 | 1.30 | 0.91 |
| Example 35 | 21 | 6.8 | 19.1 | 0.95 | 1.50 |

Example 36 shows that the effect of solvent power/solubility parameter on the resin process may be very complex. While not wishing to be bound by this theory, it appears that the solubility parameter may affect the stability of the cresol-formaldehyde transition state and the kinetics of monomer incorporation in the resin, especially when mixtures of monomers are used.

**Claims**

1. A method for adjusting the molecular weight and dissolution rate of an alkali soluble, film forming novolak resin having a high relative molecular weight and fast dissolution rate, the method comprising:

   a) providing an admixture of formaldehyde and one or more phenolic compounds and a catalytic amount of an acid catalyst;
   b) providing a suitable reaction solvent or solvent mixture having a polarity of from 3.3 to 7.0 and a hydrogen bonding capability of from 7.6 to 12.3, except diglyme and ethyl cellosolve acetate;
   c) providing a reaction mixture of the formaldehyde/phenolic compounds admixture in the reaction solvent; and
   d) reacting the reaction mixture to thereby produce a novolak resin that is the condensation product of the formaldehyde and the phenolic compounds.

2. The method of claim 1 wherein the polarity and hydrogen bonding capability of the reaction solvent are controlled by adding additional reaction solvent during the reaction.

3. The method of claim 2 wherein the polarity and hydrogen bonding capability are kept substantially constant during the reaction.

4. A method for producing a positive photoresist composition, the method comprising:

   providing an admixture of:

   1) a photosensitive component in an amount sufficient to uniformly photosentitize the photoresist composition;
   2) the novolak resin of claims 1, 2 and 3, the novolak resin being present in an amount sufficient to form a substantially uniform photoresist composition; and
   3) a suitable photoresist solvent, to thereby produce a photoresist composition.

5. A method for producing a semiconductor device by providing a photoresist image on a substrate by coating a suitable substrate with a positive working photoresist composition, the method comprising:

   a) providing an admixture of:

1) a photosensitive component in an amount sufficient to uniformly photosensitize the photoresist composition;

2) the novolak resin of claims 1, 2 and 3, the novolak resin being present in an amount sufficient to form a substantially uniform photoresist composition; and

3) a suitable photoresist solvent, to thereby produce a photoresist composition;

b) coating a suitable substrate with the photoresist composition;
c) heat treating the coated substrate until. substantially all of the solvent is removed;
d) image-wise exposing the photosensitive composition; and
e) removing the image-wise exposed areas of the photoresist composition with an aqueous alkaline developer.

6. The method of claim 5 wherein the substrate is baked either immediately before or after the exposed areas of the photoresist composition are removed.

**Patentansprüche**

1. Verfahren zur Einstellung des Molekulargewichts und der Auflösungsgeschwindigkeit eines in Alkali löslichen, filmbildenden Novolakharzes mit einem hohen relativen Molekulargewicht und einer hohen Auflösungsgeschwindigkeit, wobei das Verfahren aus folgenden Schritten besteht:

a) Herstellung eines Gemisches aus Formaldehyd und einer oder mehreren phenolischen Verbindungen und einer katalytisch wirksamen Menge eines sauren Katalysators;

b) Herstellung eines geeigneten Reaktionslösungsmittels oder Lösungsmittelgemisches, dessen Polarität zwischen 3,3 und 7,0 liegt und das ein Wasserstoffbindungsvermögen zwischen 7,6 und 12,3 aufweist, mit Ausnahme von Diglyme und Ethylcellosolveacetat;

c) Herstellung eines Reaktionsgemisches aus dem Gemisch aus Formaldehyd und phenolischen Verbindungen in dem Reaktionslösungsmittel und

d) Herbeiführen einer Reaktion des Reaktionsgemisches, so daß ein Novolakharz entsteht, bei dem es sich um das Kondensationsprodukt von Formaldehyd und den phenolischen Verbindungen handelt.

2. Verfahren gemäß Anspruch 1, wobei die Polarität und das Wasserstoffbindungsvermögen des Reaktionslösungsmittels durch weiteren Zusatz von Reaktionslösungsmittel während der Reaktion geregelt werden.

3. Verfahren gemäß Anspruch 2, wobei die Polarität und das Wasserstoffbindungsvermögen während der Reaktion weitgehend konstant gehalten werden.

4. Verfahren zur Herstellung einer positiven Photoresistzubereitung, das folgende Schritte umfaßt:

Herstellung eines Gemisches aus

1. einer für die gleichmäßige Photosensibilisierung der Photoresistzubereitung ausreichenden Menge einer lichtempfindlichen Komponente;

2. einem Novolakharz gemäß Anspruch 1, 2 und 3, wobei das Novolakharz in einer so großen Menge vorliegt, daß eine weitgehend gleichmäßige Photoresistzubereitung gebildet wird und

3. einem geeigneten Photoresistlösungsmittel, so daß eine Photoresistzubereitung entsteht.

5. Verfahren zur Herstellung eines Halbleiterelements durch Schaffung einer Photoresistabbildung auf einem Träger durch Beschichten eines geeigneten Trägers mit einer positiv arbeitenden Photoresistzubereitung, wobei dieses Verfahren folgende Schritte umfaßt:

a) Herstellung eines Gemisches aus

1. einer für die gleichmäßige Photosensibilisierung der Photoresistzubereitung ausreichenden Menge einer lichtempfindlichen Komponente;

2. einem Novolakharz gemäß Anspruch 1, 2 und 3, wobei das Novolakharz in einer so großen Menge vorliegt, daß eine weitgehend gleichmäßige Photoresistzubereitung gebildet wird und

3. einem geeigneten Photoresistlösungsmittel, so daß eine Photoresistzubereitung entsteht;

b) Beschichten eines geeigneten Trägers mit der Photoresistzubereitung;

c) Wärmebehandlung des beschichteten Trägers bis praktisch das gesamte Lösungsmittel entfernt ist;

d) abbildungsgemäße Belichtung der lichtempfindlichen Zubereitung und

e) Entfernen der abbildungsgemäß belichteten Bereiche der Photoresistzubereitung mit einem wäßrig alkalischen Entwickler.

6. Verfahren gemäß Anspruch 5, wobei der Träger entweder unmittelbar vor oder nach dem Entfernen der belichteten Bereiche der Photoresistzubereitung getrocknet wird.

**Revendications**

1. Procédé pour ajuster la masse moléculaire et la vitesse de dissolution d'une résine novolaque filmogène soluble dans une solution alcaline, ayant une masse moléculaire relative élevée et une vitesse de dissolution rapide, le procédé comprenant les étapes consistant :

a) à prendre un mélange de formaldéhyde et d'un ou de plusieurs composés phénoliques et d'une quantité catalytique d'un catalyseur acide;
b) à prendre un solvant de réaction approprié ou un mélange de solvants ayant une polarité comprise entre 3,3 et 7,0 et une capacité de liaison hydrogène de 7,6 à 12,3, saut le diglyme et l'acétate d'éthylcellulose;
c) à préparer un mélange réactionnel constitué du mélange des composés phénoliques avec le formaldéhyde dans le solvant de réaction; et
d) à mettre à réagir le mélange réactionnel pour produire ainsi une résine novolaque qui est le produit de condensation du formaldéhyde et des composés phénoliques.

2. Procédé selon la revendication 1 dans lequel la polarité et la capacité de liaison hydrogène du solvant de réaction sont contrôlés par l'ajout de solvant de réaction additionnel au cours de la réaction.

3. Procédé selon la revendication 2 dans lequel la polarité et la capacité de liaison hydrogène du solvant de réaction sont maintenus pratiquement complètement constants au cours de la réaction.

4. Procédé pour la production d'une composition de photoresist positive, le procédé comprenant les étapes consistant :

à réaliser un mélange de

1) un composé photosensible en une quantité suffisante pour photosensibiliser uniformément la composition de photoresist;
2. la résine novolaque des revendications 1, 2 et 3, la résine novolaque étant présente en une quantité suffisante pour former une composition de photoresist pratiquement complètement uniforme; et
3) un solvant de photoresist approprié, pour produire ainsi une composition de photoresist.

5. Procédé pour la production d'un dispositif semi-conducteur en produisant une image photographique sur un substrat en enduisant un substrat approprié avec une composition de photoresist travaillant en positif, le procédé comprenant les opérations consistant :

a) à réaliser un mélange de :

1) un composé photosensible en une quantité suffisante pour photosensibiliser uniformément la composition de photoresist;

2. la résine novolaque des revendications 1, 2 et 3, la résine novolaque étant présente en une quantité suffisante pour former une composition de photoresist pratiquement complètement uniforme; et

3) un solvant de photoresist approprié, pour produire ainsi une composition de photoresist.

b) à enduire un substrat approprié avec la composition de photoresist;

c) à traiter thermiquement le substrat enduit jusqu'à enlèvement de pratiquement tout le solvant;

d) à exposer selon une image la composition photosensible; et

g) à éliminer la composition de photoresist des zones exposées avec un révélateur alcalin aqueux.

6. Procédé selon la revendication 5 dans lequel le substrat est cuit soit immédiatement avant ou après l'élimination de la composition de photoresist des zones exposées.

# FIG. I

DELTA P vs DELTA H FOR SINGLE SOLVENTS

| RMW | Diss Rate | | RMW | Diss Rate |
|-----|-----------|--|-----|-----------|
| 8.0 | 0.68 | | II.3 | 0.7I |

2-ethyl-I-hexanol                    DPGME

Model:
Linear

Response:
RMV

Variables:
X=deltap
Y= deltah

dioxane                              diglyme

| RMW | Diss Rate | | RMW | Diss Rate |
|-----|-----------|--|-----|-----------|
| 8.9 | 4.I2 | | 9.4 | 2.86 |

# FIG.2

Model:
Linear

Response:
RMW

Variables:
X = deltap
Y = deltah

# FIG.3

Model:
Linear

Response:
dissrate

Variables:
X = deltap
Y = deltah

# FIG. 4

## DELTA P vs DELTA H FOR MIXED SOLVENTS

RMW    Diss Rate
8.0       0.68
2-ethyl-1-hexanol

RMW    Diss Rate
11.3      0.71
DPGME

Model:
Linear

Response:
RMV

Variables:
X = deltap
Y = deltah

X2: deltah

12.30
11.92
11.53
11.15
10.77
10.38
10.00

3.000 3.667 4.333 5.000 5.667 6.333 7.000

X1: deltap

25% xylene
75% 2-ethyl-1-hexanol
RMW  Diss Rate
8.9       2.02

25% xylene
75% DPGME
RMW  Diss Rate
9.5       2.37

## FIG. 5

Model:
Linear

Response:
RMW

Variables:
X = deltap
Y = deltah

DESIGN-EXPERT Analysis

X2: deltah

XI: deltap

## FIG. 6

Model:
Linear

Response:
DISS RATE

Variables:
X = deltap
Y = deltah

DESIGN EXPERT Analysis

X2: deltah

XI: deltap